(19) Europäisches Patentamt
European Patent Office
Office européen des brevets

(11) **EP 4 073 525 B1**

(12) **EUROPÄISCHE PATENTSCHRIFT**

(45) Veröffentlichungstag und Bekanntmachung des Hinweises auf die Patenterteilung:
**11.12.2024 Patentblatt 2024/50**

(21) Anmeldenummer: **20797735.6**

(22) Anmeldetag: **27.10.2020**

(51) Internationale Patentklassifikation (IPC):
**G01R 19/32** *(2006.01)* **H02M 3/337** *(2006.01)*
**G01R 19/00** *(2006.01)* **H02M 1/00** *(2006.01)*
**H02M 3/335** *(2006.01)*

(52) Gemeinsame Patentklassifikation (CPC):
**G01R 19/32; H02M 3/3376;** G01R 19/0092;
H02M 1/0009; H02M 3/33584

(86) Internationale Anmeldenummer:
**PCT/EP2020/080123**

(87) Internationale Veröffentlichungsnummer:
**WO 2021/115675 (17.06.2021 Gazette 2021/24)**

(54) **VORRICHTUNG ZUR MESSUNG EINES STROMS DURCH EINE DROSSEL UND VERFAHREN ZUM BETRIEB EINER VORRICHTUNG ZUR MESSUNG EINES STROMS DURCH EINE DROSSEL**

DEVICE FOR MEASURING A CURRENT THROUGH A CHOKE AND METHOD FOR OPERATING A DEVICE FOR MEASURING A CURRENT THROUGH A CHOKE

DISPOSITIF DE MESURE D'UN COURANT À TRAVERS UNE BOBINE D'ARRÊT ET PROCÉDÉ DE FONCTIONNEMENT D'UN DISPOSITIF DE MESURE D'UN COURANT À TRAVERS UNE BOBINE D'ARRÊT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.12.2019 DE 102019219488**

(43) Veröffentlichungstag der Anmeldung:
**19.10.2022 Patentblatt 2022/42**

(73) Patentinhaber: **Robert Bosch GmbH**
**70442 Stuttgart (DE)**

(72) Erfinder: **MUELLER, Stephan**
**71672 Marbach Am Neckar (DE)**

(56) Entgegenhaltungen:
CN-A- 104 638 885      JP-A- 2010 011 294
KR-A- 20110 012 116      US-A1- 2018 340 964

- TSANG K M ET AL: "Temperature compensated high efficiency inductor current sensor", SENSORS AND ACTUATORS A: PHYSICAL, ELSEVIER BV, NL, vol. 154, no. 1, 31 August 2009 (2009-08-31), pages 16 - 22, XP026498367, ISSN: 0924-4247, [retrieved on 20090702], DOI: 10.1016/J.SNA.2009.06.012
- LEVIGION M: "Temperatur-Kompensation elektrischer Groessen", TECHNISCHES MESSEN ATM, R.OLDENBOURG VERLAG. MUNCHEN, DE, vol. z119-8, no. 452, 1 September 1973 (1973-09-01), pages 177 - 180, XP002163913

**Beschreibung**

Die Erfindung betrifft eine Vorrichtung zur Messung eines Stroms durch eine Drossel und Verfahren zum Betrieb einer Vorrichtung zur Messung eines Stroms durch eine Drossel. Ferner betrifft die Erfindung einen Antriebsstrang mit einer Vorrichtung, ein Fahrzeug mit einem Antriebsstrang sowie ein Computerprogramm und ein maschinenlesbares Speichermedium.

Stand der Technik

Die Druckschriften TSANG KM ET AL: "Temperature compensated high efficiency inductor current sensor", SENSORS AND ACTUATORS A: PHYSICAL, ELSEVIER BV, NL, Bd. 154, Nr. 1, 31. August 2009 (2009-08-31), Seiten 16-22, XP026498367, ISSN: 0924-4247, CN 104 638 885 B, US 2018/340964 A1, KR 2011 0012116 A, LEVIGION M: "Temperatur-Kompensation elektrischer Groessen", TECHNISCHES MESSEN ATM, R.OLDENBOURG VERLAG. MUN-CHEN, DE, Bd. 2119-8, Nr. 452, 1. September 1973 (1973-09-01), Seiten 177-180, XP002163913 und JP 2010 011294 A offenbaren Strommessverfahren. Strommessverfahren sind bekannt, bei denen ein Strom in einem leistungselektronischen System, beispielsweise in einem Gleichspannungswandler, über den Spannungsabfall beispielsweise einer Glättungs-Drossel gemessen werden kann. Hierfür wird kein separater Shunt-Widerstand benötigt. Solche Verfahren sind als "DCR Current Sensing" bekannt, bei dem das Kürzel "DCR" für"DC-Resistance" der Drossel steht. Hierbei wird indirekt der Strom durch die Drossel gemessen, indem der Spannungsabfall an der Drossel erfasst und fortlaufend integriert wird. Über die Integration der Spannung erhält man den gemessenen Strom. Hierfür wird eine Integrator-Schaltung benutzt, die auf die elektrischen Eigenschaften der Drossel abgestimmt wird, beispielsweise mittels eines RC-Tiefpass, beispielsweise einer Reihenschaltung aus Widerstand und Kondensator parallel zu der Drossel. Bei sehr schnellen Stromänderungen dominiert der induktive Anteil des Spannungsabfalls der Drossel gegenüber dem Spannungsabfall am Kupferwiderstand der Drossel. Für Gleichströme dagegen fällt keine Spannung an der Induktivität mehr ab, sodass der Strom direkt über den ohmschen Kupferwiderstand der Drossel gemessen werden kann. Die Integratorschaltung wird so dimensioniert, dass deren Zeitkonstante bzw. deren Eckfrequenz nahezu identisch ist mit der Zeitkonstante bzw. der Eckfrequenz der Drossel. Die Zeitkonstante der Integratorschaltung entspricht dem Produkt aus ohmschen Widerstand und Kapazität der Integratorschaltung (R*C). Die Zeitkonstante der Drossel entspricht dem Quotienten aus der Induktivität der Drossel durch den ohmschen Widerstand der Drossel (L/Rdc). Für identische Zeitkonstanten entspricht folglich das Produkt aus ohmschen Widerstand und Kapazität der Integratorschaltung dem Quotienten aus der Induktivität der Drossel durch den ohmschen Widerstand der Drossel (R*C = L/Rdc). Damit wird sichergestellt, dass die Gesamtübertragungsfunktion über den kompletten Frequenzbereich konstant ist. Die Übertragungsfunktion der Drossel lautet: Rdc + s*L, bzw. die des RC-Filters der Integratorschaltung: 1/(1 + s*R*C), mit s = jω. Multipliziert man beide Funktionen, erhält man die Gesamtübertragungsfunktion:

$$G(s) = R_{dc} * \frac{(1 + s * \frac{L}{R_{dc}})}{(1 + s * R * C)}$$

Sind beide Zeitkonstanten gleich, dann beträgt der frequenzabhängige Anteil immer 1 und somit gilt: G(s) = Rdc.
Vorteile dieses Messprinzips gegenüber anderen Stromsensoren, wie z.B. einem Shunt-Widerstand, sind die geringeren Stückkosten, der geringere Platzbedarf, sowie eine verlustfreie Strommessung. Die Messgenauigkeit ist jedoch begrenzt, da der Kupferwiderstand der Drossel produktionsbedingt hohe Toleranzen hat, sowie stark temperaturabhängig ist. Eine Temperaturkompensation kann mittels parallel zum Kondensator der Integratorschaltung geschalteten NTC-Widerstand erfolgen. Der temperaturabhängige Verstärkungsfaktor der Sensorschaltung wird so variiert, dass er dem Temperaturkoeffizienten des Kupferwiderstands der Drossel entgegenwirkt und somit den Temperatureinfluss nahezu kompensiert.
Das vorgestellte Schaltungskonzept ermöglicht jedoch keine Messung des Stroms, wenn dieser nicht nur schwankt, sondern die Flussrichtung ändert und bidirektional fließt. Entstehende negative Spannungsmesssignale können nicht ohne weiteren schaltungstechnischen Aufwand verarbeitet werden. Bekannt ist, in solchen Fällen den Nullpunkt mittels einer injizierten Bias-Offsetspannung zu verschieben, um dadurch den Messbereich für negative Ströme aufzuweiten und folglich stets positive Spannungsmesssignale auszugeben. Die Temperaturkompensation mittels NTC-Widerstand verändert aber temperaturabhängig die Offsetspannung, wodurch folglich der Stromwert nicht mehr korrekt aus dem Spannungsmesssignal ableiten lässt.
Daher besteht Bedarf für alternative Messschaltungen.

Offenbarung der Erfindung

Es wird eine Vorrichtung zur Messung eines Stroms durch eine Drossel eines Spannungswandlers mit einer Integratorschaltung, einer Verstärkerschaltung und einem NTC-Widerstand bereitgestellt. Durch die Drossel des Spannungswandlers fließt ein Laststrom. Die Drossel ist ausgangsseitig mit einem Ausgangsanschluss des Spannungswandlers verbunden. Die Integratorschaltung ist parallel zu der Drossel angeordnet.

Die Integratorschaltung umfasst eine Reihenschaltung aus einem Integratorwiderstand und einem Integratorkondensator. Der Integratorkondensator ist ebenfalls mit dem Ausgangsanschluss des Spannungswandlers verbunden. Ein Mittenabgriff zwischen dem Integratorwiderstand und dem Integratorkondensator ist als Ausgang der Integratorschaltung ausgebildet. An diesem Ausgang der Integratorschaltung liegt ein Integratorausgangssignal an. Die Verstärkerschaltung umfasst einen invertierenden und einen nichtinvertierenden Verstärkereingangsanschluss und einen Verstärkerausgangsanschluss. Dem nichtinvertierenden Verstärkereingangsanschluss wird ein Verstärkereingangssignal in Abhängigkeit des Integratorausgangssignals zugeführt. Am Verstärkerausgangsanschluss der Verstärkerschaltung liegt ein den Strom durch die Drossel charakterisierendes Spannungssignal an. Der NTC-Widerstand ist im Rückkoppelpfad der Verstärkerschaltung zwischen dem invertierenden Verstärkereingangsanschluss und dem Verstärkerausgangsanschluss angeordnet.

Es wird eine Vorrichtung bereitgestellt zur Messung eines, bevorzugt bidirektionalen, Stroms durch eine Drossel, die bevorzugt sekundärseitig am Ausgang eines Spannungswandlers als Glättungsdrossel ausgebildet ist. Die Vorrichtung umfasst eine Integratorschaltung und eine, bevorzugt aktive, Verstärkerschaltung. Wobei am Ausgang der Integratorschaltung ein Integratorausgangssignal anliegt. Dem nichtinvertierenden Verstärkereingangsanschluss wird ein Verstärkereingangssignal in Abhängigkeit des Integratorausgangssignals zugeführt, bevorzugt ist hierzu der Ausgang der Integratorschaltung mit dem nichtinvertierenden Verstärkereingangsanschluss elektrisch verbunden, bevorzugt direkt verbunden. Der NTC-Widerstand ist im Rückkoppelpfad der Verstärkerschaltung zwischen dem invertierenden Verstärkereingangsanschluss und dem Verstärkerausgangsanschluss angeordnet.

Vorteilhaft wird eine Vorrichtung bereitgestellt, bei der der NTC Widerstand unabhängig von einer möglichen Offsetspannung angeordnet wird und eine unverfälschte Messung bidirektionaler Ströme ermöglicht. Da der NTC-Widerstand von einer potentiellen Nullpunkt-Offsetgenerierung entkoppelt wird, wird eine Beeinträchtigung durch den NTC-Widerstand vermieden. Es wird eine Erweiterung der Messschaltung bei einer DCR-Strommessung für bidirektionale Ströme ohne die Verwendung einer bipolaren Versorgungsspannung unter Beibehaltung der Temperaturkompensation mittels NTC-Widerstand und aktiver Verstärkerschaltung bereitgestellt.

In einer anderen Ausgestaltung der Erfindung umfasst die Verstärkerschaltung einen Operationsverstärker.

Die Verstärkerschaltung umfasst einen Operationsverstärker, welcher bevorzugt als nicht invertierender Operationsverstärker arbeitet. Vorteilhaft wird eine Möglichkeit geschaffen, eine effiziente Verstärkerschaltung bereitzustellen, die eine wirtschaftliche Umsetzung der Vorrichtung ermöglicht. Bevorzugt wird eine zusätzliche aktive Verstärkerschaltung mittels Operationsverstärker verwendet, wobei die Verstärkerstufe auch zur Verstärkung des Nutzsignals, insbesondere des Integratorausgangssignals, verwendet wird, um somit eine verbesserte Auflösung des Nutzsignals zu erzielen. Bevorzugt wird die Verstärkung des Nutzsignals angewendet, wenn der Kupferwiderstand der Drosselspule sehr klein ist im Verhältnis zum gemessenen Strom.

Die erfindungsgemäße Vorrichtung umfasst eine Referenzspannungsquelle mit einem positiven Quellenanschluss und einem negativen Quellenanschluss. Mittels der Referenzspannungsquelle wird eine erste Offsetspannung am Ausgang der Integratorschaltung eingekoppelt. Hierzu wird der negative Quellenanschluss mit dem Ausgangsanschluss des Spannungswandlers verbunden, der positive Quellenanschluss wird über einen Koppelwiderstand mit dem Ausgang der Integratorschaltung verbunden.

Mittels einer Referenzspannungsquelle wird eine erste Offsetspannung am Ausgang der Integratorschaltung eingekoppelt. Folglich wird das Potential des Integratorausgangssignals angehoben. Dies ermöglicht die Nutzung der Schaltung auch für Ströme, die in umgekehrte Richtung fließen. Vorteilhaft wird eine Vorrichtung bereitgestellt, mit der bidirektionale Ströme ermittelt werden können.

Bevorzugt wird der Nullpunkt-Offset, die erste Offsetspannung, am Ausgang der Integratorschaltung mittels der Referenzspannungsquelle generiert, die über den Koppelwiderstand in den Signalpfad, das Integratorausgangssignal, eingekoppelt wird.

In einer anderen Ausgestaltung der Erfindung wird mittels der Referenzspannungsquelle eine zweite Offsetspannung in den Rückkoppelpfad an dem invertierenden Verstärkereingangsanschluss der Verstärkerschaltung eingekoppelt. Bevorzugt wird der negative Quellenanschluss mit dem Ausgangsanschluss des Spannungswandlers verbunden und der positive Quellenanschluss über einen Spannungsteiler, mit einem ersten, zweiten und dritten Spannungsteilerwiderstand, mit dem Ausgangsanschluss des Spannungswandlers verbunden. Weiter ist bevorzugt ein Abgriff zwischen dem zweiten und dem dritten Spannungsteilerwiderstand mit dem invertierenden Verstärkereingangsanschluss verbunden.

Mittels der Referenzspannungsquelle wird eine zweite Offsetspannung an den invertierenden Verstärkereingangsanschluss der Verstärkerschaltung eingekoppelt. Vorteilhaft ergibt sich die Möglichkeit, bevorzugt mittels Dimensionierung der Spannungsteilerwiderstände, dass sich die zweite Offsetspannung am invertierenden Eingang des Operationsverstärkers identisch zur Spannung am nichtinvertierenden Eingang einstellt, auch wenn kein Strom durch Drossel fließt. Bevorzugt bleibt auch bei steigenden Strömen durch die Drossel die zweite Offsetspannung gleich.

Bevorzugt arbeitet die Verstärkerschaltung oder der Operationsverstärker als nichtinvertierender Verstärker. Ändert sich temperaturabhängig der NTC-Widerstand, so verändert sich gleichzeitig auch der lineare Verstärkungsfaktor der Schaltung, da der NTC-Widerstand den Teilerfaktor im Rückkoppelpfad verändert. Damit eine dritte Offsetspannung am Ausgang der Verstärkerschaltung unabhängig von der Temperatur konstant bleibt, wird die Referenzspannungsquelle auch in den Rückkoppelpfad der Verstärkerschaltung eingespeist. Dabei bilden die, bevorzugt drei, Spannungsteilerwiderstände einen Spannungsteiler. Durch geeignete Dimensionierung der Widerstände wird die zweite Offsetspannung am invertierendem Eingang der Verstärkerschaltung nahezu identisch zur Spannung am nichtinvertierendem Eingang eingestellt. Steigt der zu messende Strom durch die Drossel von 0A auf höhere Werte an, so wird nur der Spannungsanstieg aufgrund der Stromänderung verstärkt. Bevorzugt bleiben die erste, zweite und dritte Offsetspannung gleich, wenn kein Strom durch die Drossel fließt.

In einer anderen Ausgestaltung der Erfindung ist in dem Rückkoppelpfad der Verstärkerschaltung zwischen dem invertierenden Verstärkereingangsanschluss und dem Verstärkerausgangsanschluss ein serieller Widerstand in Reihe zu dem NTC-Widerstand und ein paralleler Widerstand parallel zu der Reihenschaltung aus seriellem Widerstand und NTC-Widerstand angeordnet.

Es ist ein serieller Widerstand zum NTC-Widerstand und ein paralleler Widerstand parallel zu der Reihenschaltung aus seriellen und NTC-Widerstand angeordnet. Diese drei Widerstände sind im Rückkoppelpfad der Verstärkerschaltung zwischen dem invertierenden Verstärkereingangsanschluss und dem Verstärkerausgangsanschluss angeordnet. Vorteilhaft wird eine Schaltungsanordnung zur Linearisierung des NTC-Widerstandes über der Temperatur. Dieser verhält sich ohne dieser Schaltungsanordnung nichtlinear über der Temperatur.

Bevorzugt dient der serielle Widerstand zum NTC-Widerstand und ein paralleler Widerstand parallel zu der Reihenschaltung aus seriellen und NTC-Widerstand zur Linearisierung des NTC-Widerstands über der Temperatur, da der NTC-Widerstand sich über Temperatur nichtlinear verhält. Der serielle Widerstand hat die Funktion, die Gesamtimpedanz aus NTC-Widerstand, dem seriellen Widerstand und dem parallelen Widerstand bei Hochtemperatur nicht zu klein werden zu lassen. Der parallele Widerstand hat dagegen die Funktion, die Gesamtimpedanz aus NTC-Widerstand, dem seriellen Widerstand und dem parallelen Widerstand bei Tieftemperatur nicht zu hochohmig werden zu lassen.

In einer anderen Ausgestaltung der Erfindung ist ein erster Filterkondensator parallel zu dem NTC-Widerstand angeordnet.

Vorteilhaft wird eine Schaltungsanordnung bereitgestellt, die den Verstärkungsfaktor frequenzselektiv einstellt. Der parallel zum NTC-Widerstand geschaltete erste Filterkondensator schließt den NTC-Widerstand zu höheren Frequenzen hin kurz, sodass dieser ab einer bestimmten oder bestimmbaren Eckfrequenz nicht mehr wirkt.

In einer anderen Ausgestaltung der Erfindung ist ein zweiter Filterkondensator parallel zu dem ersten Spannungsteilerwiderstand oder dem zweiten Spannungsteilerwiderstand angeordnet.

Vorteilhaft wird eine Schaltungsanordnung bereitgestellt, die den Verstärkungsfaktor frequenzselektiv einstellt. Der parallel zum ersten oder zweiten Spannungsteilerwiderstand geschaltete zweite Filterkondensator schließt den ersten oder zweiten Spannungsteilerwiderstand zu höheren Frequenzen hin kurz, sodass dieser ab einer bestimmten oder bestimmbaren Eckfrequenz nicht mehr wirkt und nur noch einer der beiden Spannungsteilerwiderstande wirkt. Bevorzugt wirkt somit der NTC-Widerstand frequenzselektiv nur bei tiefen Frequenzen unterhalb einer bestimmten oder bestimmbaren Eckfrequenz, bevorzugt der Eckfrequenz der Drossel, die sich aus dem Quotient deren Induktivität und Kupferwiderstand ergibt.

Bevorzugt wird eine Verstärkerschaltung bereitgestellt, welche den Messbereich für bidirektionale Ströme und gleichzeitig die Temperaturkompensation mittels NTC-Widerstand ermöglicht, wobei der NTC-Widerstand nicht mit dem Ausgang der Integratorschaltung verbunden ist, sondern im Rückkoppelpfad der Verstärkerschaltung angeordnet ist.

Weiter werden bevorzugt die Zeitkonstanten der Drossel und der Integratorschaltung über der Temperatur möglichst konstant gehalten, um den Verstärkungsfaktor der Vorrichtung zur Messung des Stroms durch eine Drossel, also der Sensorschaltung, über den Frequenzbereich konstant zu halten. Wäre dies nicht der Fall, so könnte der die Vorrichtung zur Messung des Stroms durch eine Drosselbei schnellen Stromänderungen einen Messfehler erzeugen bzw. umgekehrt im Falle eine Kurzschlussüberwachung den Strom zu langsam messen. Da der NTC-Widerstand in dieser Schaltung nun nicht mehr mit dem Ausgang der Integratorschaltung verbunden ist, wird mittels des ersten und des zweiten Filterkondensators der Verstärkungsfaktor frequenzselektiv so eingestellt, dass er sowohl über Temperatur als auch über den Frequenzbereich hinweg konstant bleibt. Der erste Filterkondensator schließt den NTC-Widerstand zu höheren Frequenzen hin kurz, sodass er ab einer bestimmten Eckfrequenz nicht mehr wirkt, bzw. nicht mehr zur Gesamtverstärkung beiträgt. Mit dem zweiten Filterkondensator wird die Wirkung des ersten Spannungsteilerwiderstands für höhere Frequenzen ausgeschaltet, sodass dann nur noch der zweite Spannungsteilerwiderstand zur Gesamtverstärkung beiträgt. Dadurch lässt sich der Verstärker so einstellen, dass der NTC-Widerstand frequenzselektiv nur in einem bestimmten Frequenzbereich wirkt, bevorzugt zu tiefen Frequenzen hin, bevorzugt nur bei tiefen Frequenzen unterhalb einer bestimmten oder bestimmbaren Eckfrequenz, bevorzugt der Eckfrequenz der Drossel, die sich aus dem Quotient deren Induktivität und Kupferwiderstand ergibt.

Bevorzugt wird somit die Nullpunkt-Offsetgenerierung vom NTC-Widerstand entkoppelt und folglich eine bidirektionale Strommessung ermöglicht. Dabei werden die erste, zweite und die dritte Offsetspannung nicht über die Temperatur beeinträchtigt und auch eine konstante Gesamtübertragungsfunktion über die Frequenz hinweg beibehalten.

Ferner betrifft die Erfindung einen Spannungswandler mit einer beschriebenen Vorrichtung. Der Spannungswandler ist hierzu als Wechselrichter, als Gleichspannungswandler oder als Ladegerät ausgebildet.

Vorteilhaft wird ein spezieller Spannungswandler mit einer Vorrichtung zur Messung eines Stroms durch eine Drossel bereitgestellt.

Ferner betrifft die Erfindung einen Antriebsstrang eines Fahrzeugs mit einem Spannungswandler. Einen derartigen Antriebsstrang mit einem Spannungswandler und einer beschriebenen Vorrichtung dient beispielsweise dem Antrieb eines elektrischen Fahrzeugs. Mittels der Vorrichtung wird eine effiziente Möglichkeit zur Messung eines Stroms durch eine Drossel bereitgestellt.

Ferner betrifft die Erfindung ein Fahrzeug, mit einem beschriebenen Antriebsstrang. Vorteilhaft wird somit ein Fahrzeug bereitgestellt, welches eine Vorrichtung umfasst, mit der effizient ein Strom durch eine Drossel gemessen wird.

Ferner betrifft die Erfindung ein Verfahren zum Betrieb einer Vorrichtung mit den Schritten: Ermitteln des Stroms durch eine Drossel eines Spannungswandlers und Steuern des Spannungswandlers in Abhängigkeit des ermittelten Stroms.

Vorteilhaft wir ein Verfahren für eine effiziente Messung eines Stroms durch eine Drossel bereitgestellt.

Ferner betrifft die Erfindung ein Computerprogramm, welches Befehle umfasst, die bei der Ausführung durch einen Computer diesen veranlassen, die Schritte des bisher beschriebenen Verfahrens auszuführen.

Ferner betrifft die Erfindung ein computerlesbares Speichermedium, umfassend Befehle, die bei der Ausführung durch einen Computer diesen veranlassen, die Schritte des bisher beschriebenen Verfahrens auszuführen.

Es versteht sich, dass die Merkmale, Eigenschaften und Vorteile der Vorrichtung entsprechend auf das Verfahren bzw. den Antriebsstrang und das Fahrzeug und umgekehrt zutreffen bzw. anwendbar sind.

Weitere Merkmale und Vorteile von Ausführungsformen der Erfindung ergeben sich aus der nachfolgenden Beschreibung mit Bezug auf die beigefügten Zeichnungen.

Kurze Beschreibung der Zeichnung

Im Folgenden soll die Erfindung anhand einiger Figuren näher erläutert werden, dazu zeigen:

Figur 1

eine schematische Darstellung eines Spannungswandlers mit einer Drossel.

Figur 2

eine schematische Darstellung einer Vorrichtung zur Messung eines Stroms durch eine Drossel eines Spannungswandlers.

Figur 3

ein schematisches Diagramm welches den unkompensierten Verlauf der Gesamtübertragungsfunktion über der Frequenz bei verschiedenen Temperaturen zeigt.

Figur 4

ein schematisches Diagramm welches den kompensierten Verlauf der Gesamtübertragungsfunktion über der Frequenz bei verschiedenen Temperaturen zeigt.

Figur 5

ein schematisches Diagramm welches den unkompensierten Verlauf der Gesamtübertragungsfunktion über der Frequenz bei verschiedenen Temperaturen ohne Filterkondensatoren zeigt.

Figur 6

ein schematisches Diagramm welches den teilkompensierten Verlauf der Gesamtübertragungsfunktion über der Frequenz bei verschiedenen Temperaturen mit dem ersten Filterkondensator zeigt.

Figur 7

ein schematisches Diagramm welches den kompensierten Verlauf der Gesamtübertragungsfunktion über der Frequenz bei verschiedenen Temperaturen mit dem ersten und dem zweiten Filterkondensator zeigt.

Figur 8

ein schematisch dargestelltes Verfahren zum Betrieb der Vorrichtung.

Figur 9

ein schematisch dargestelltes Fahrzeug mit einem Antriebsstrang und einem Spannungswandler.

Ausführungsformen der Erfindung

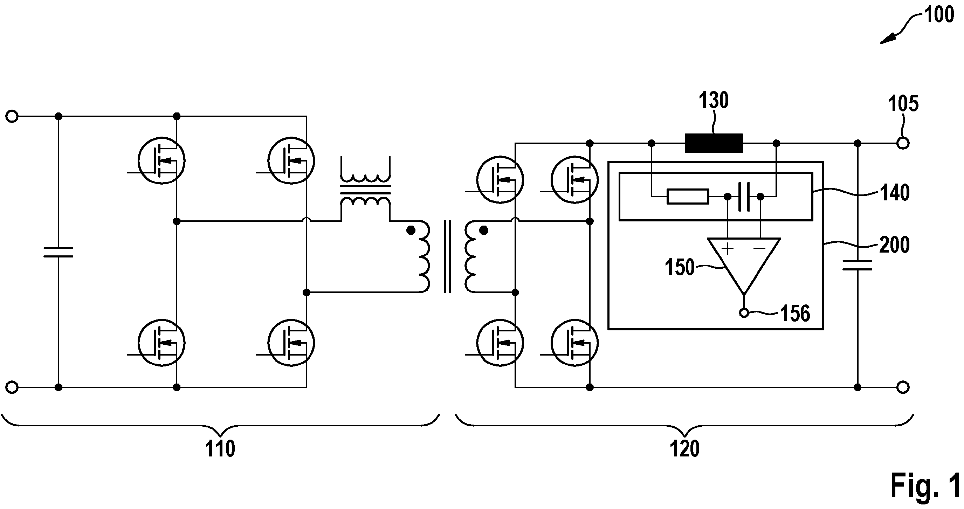

Die Figur 1 zeigt eine schematische Darstellung eines Spannungswandlers 100 mit einer Drossel 130. Der Spannungswandler 100 ist bevorzugt als Wechselrichter, als Gleichspannungswandler oder als Ladegerät ausgebildet. In der Figur 1 wird ist er beispielhaft als Gleichspannungswandler dargestellt. Dieser umfasst einen Primärkreis 110 und einen Sekundärkreis 120, welche mittels eines Transformators galvanisch voneinander getrennt sind. Der Sekundärkreis 120 umfasst am Ausgang eine Drossel 130, bevorzugt eine Glätttungsdrossel, welche ausgangsseitig des Spannungswandlers 100 mit dem Ausgangsanschluss 105 des Spannungswandlers 100 verbunden ist. Durch diese Drossel 130 fließt während des Betriebs des Spannungswandlers 100 ein Strom, oder der Laststrom, des Spannungswandlers 100, wenn elektrische Energie vom Primärkreis 110 zu dem Sekundärkreis 120 transportiert wird oder andersrum. Weiter zeigt die Figur 1 eine Vorrichtung 200 zur Messung eines Stroms durch die Drossel 130 des Spannungswandlers 100. Die Vorrichtung umfasst eine parallel zu der Drossel 130 angeschlossene Integratorschaltung 140. Weiter umfasst die Vorrichtung 200 eine Verstärkerschaltung. Das Integratorausgangssignal der Integratorschaltung 140 wird mittels einer Verstärkerschaltung, oder mittels des dargestellten Operationsvertärkers 150, weiterverarbeitet. Am Verstärkerausgangsanschluss 156 der Verstärkerschaltung liegt ein den Strom durch die Drossel 130 charakterisierendes Spannungssignal an.

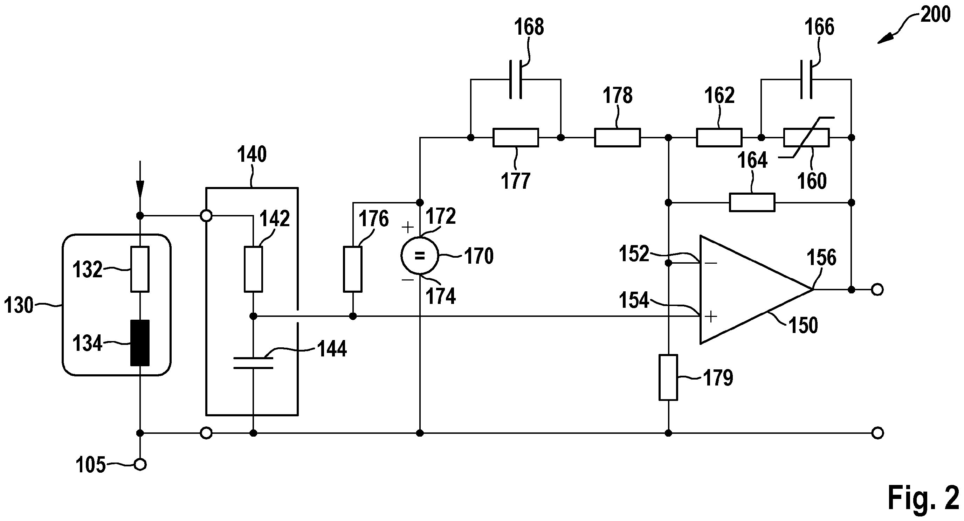

Figur 2 zeigt eine Vorrichtung 200 zur Messung eines Stroms durch eine Drossel 130 eines Spannungswandlers 100. Die Figur 1 zeigt den Ausgangsanschluss 105 des Spannungswandlers 100 und die daran angeschlossene Drossel 130, welche im Sinne eines Ersatzschaltbildes als ohmscher Gleichstromdrosselwiderstand 132 und als Induktivität 134 der Drossel 130 dargestellt sind. Die Vorichtung umfasst die parallel zu der Drossel 130 angeschlossene Integratorschaltung 140. Weiter umfasst die Vorrichtung 200 eine Verstärkerschaltung und einem NTC-Widerstand 160. Ein Laststrom des Spannungswandlers 100 fließt durch die Drossel 130. Die Integratorschaltung 140 umfasst eine Reihenschaltung aus einem Integratorwiderstand 142 und einem Integratorkondensator 144. Der Integratorkondensator 144 ist ebenfalls mit dem Ausgangsanschluss 105 des Spannungswandlers 100 verbunden. Ein Mittenabgriff ist zwischen dem Integratorwiderstand 142 und dem Integratorkondensator 144 als Ausgang der Integratorschaltung 140 ausgebildet. An diesem Ausgang der Integratorschaltung 140 liegt ein Integratorausgangssignal an. Die Verstärkerschaltung umfasst einen invertierenden und einen nichtinvertierenden Verstärkereingangsanschluss 152, 154 und einen Verstärkerausgangsanschluss 156. Dem nichtinvertierenden Verstärkereingangsanschluss 154 wird ein Verstärkereingangssignal in Abhängigkeit des Integratorausgangssignals zugeführt. Ein den Strom durch die Drossel 130 charakterisierendes Spannungssignal liegt am Verstärkerausgangsanschluss 156 der Verstärkerschaltung an. Der NTC-Widerstand 160 ist im Rückkoppelpfad der Verstärkerschaltung zwischen dem invertierenden Verstärkereingangsanschluss 152 und dem Verstärkerausgangsanschluss 156 angeordnet. Bevorzugt umfasst die Verstärkerschaltung einen Operationsverstärker 150, welcher bevorzugt als nichtinvertierender Operationsverstärker arbeitet. Die Vorrichtung 200 umfasst eine Referenzspannungsquelle 170 mit einem positiven Quellenanschluss 172 und einem negativen Quellenanschluss 174. Mittels der Referenzspannungsquelle 170 wird eine erste Offsetspannung am Ausgang der Integratorschaltung 140 eingekoppelt. Der negative Quellenanschluss 174 wird mit dem Ausgangsanschluss 105 des Spannungswandlers 100 verbunden. Der positive Quellenanschluss 172 wird über einen Koppelwiderstand 176 mit dem Ausgang der Integratorschaltung 140 verbunden. Bevorzugt wird weiter mittels der Referenzspannungsquelle 170 eine zweite Offsetspannung in den Rückkoppelpfad an dem invertierenden Verstärkereingangsanschluss 152 der Verstärkerschaltung eingekoppelt. Bevorzugt ist der positive Quellenanschluss 172 über einen Spannungsteiler aus einem ersten, zweiten und dritten Spannungsteilerwiderstand 177, 178, 179 mit dem Ausgangsanschluss 105 des Spannungswandlers 100 verbunden. Bevorzugt ist ein Abgriff zwischen dem zweiten und dem dritten Spannungsteilerwiderstand 178, 179 mit dem invertierenden Verstärkereingangsanschluss 152 verbunden. Bevorzugt ist in dem Rückkoppelpfad der Verstärkerschaltung zwischen dem invertierenden Verstärkereingangsanschluss 152 und dem Verstärkerausgangsanschluss 156 ein serieller Widerstand 162 in Reihe zu dem NTC-Widerstand 160 und ein paralleler Widerstand 164 parallel zu der Reihenschaltung aus seriellem Widerstand 162 und NTC-Widerstand 160 angeordnet. Weiter bevorzugt ist ein erster Filterkondensator 166 parallel zu dem NTC-Widerstand 160 angeordnet und/ oder ein zweiter Filterkondensator 168 parallel zu dem ersten Spannungsteilerwiderstand 177.

Ein mögliches Versorgungskonzept für die Vorrichtung ist Folgendes: Gemäß Figur 2 liegt das Bezugspotential der Verstärkerschaltung oder des Operationsverstärkers 150 auf der Spannung nach der Drossel am Ausgangsanschluss 105, bevorzugt am Ausgang eines Schaltnetzteils oder eines Gleichspannungswandlers. Bevorzugt wird eine Versorgungsspannung zur Versorgung der Verstärkerschaltung benötigt, welche größer ist, als die Spannung am Ausgangsanschluss 105. Bevorzugt wäre eine Ladungspumpe zu verwenden oder die Generierung einer sog. Highside-Hilfsspannung. Das Spannungssignal am Verstärkerausgangsanschluss 156 wird bevorzugt mittels einer weiteren Schaltung auf das Masse-Potential transferiert, beispielsweise mittels einem Highside-Messverstärker oder ein Stromspiegel.

Alternativ wird das Integratorausgangssignal bevorzugt über einen Differenzverstärker oder einem bidirektionalen Highside-Strommessverstärker auf das Masse-Bezugspotential des Spannungswandlers transferiert, um es dann weiter zu verarbeiten, bevorzugt dem nichtinvertierenden Verstärkereingangsanschluss 154 als Verstärkereingangssignal in Abhängigkeit des Integratorausgangssignals zuzuführen. Dabei ist das Bezugspotential für die Referenzspannungsquelle und die Verstärkerschaltung das Masse-Bezugspotential des Spannungswandlers.

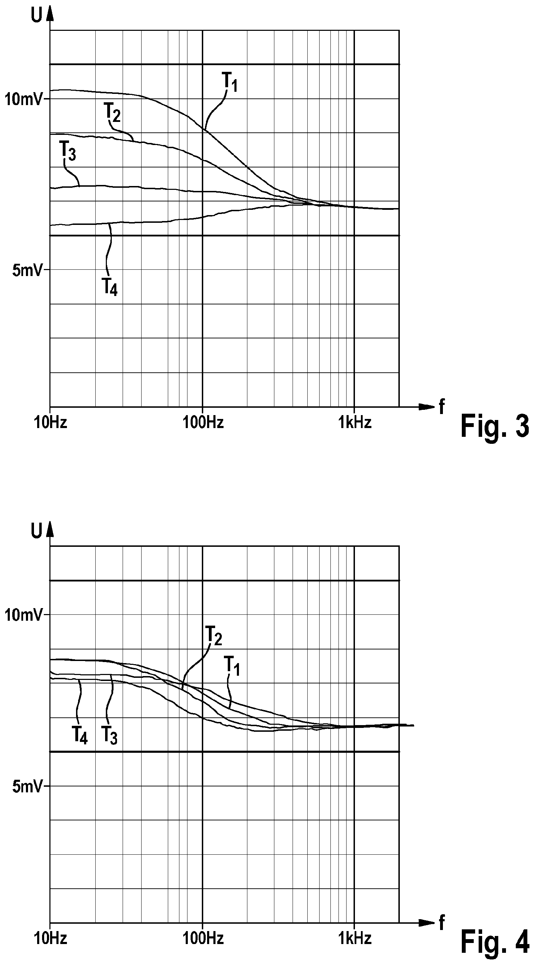

Die Figur 3 zeigt ein schematisches Diagramm welches den unkompensierten Verlauf der Gesamtübertragungsfunktion in mV (pro A) über der Frequenz bei verschiedenen Temperaturen (T1, T2, T3, T4) zeigt. Für geringe Frequenzen ist ein weites Auffächern der Gesamtübertragungsfunktion bei verschiedenen Temperaturen (T1, T2, T3, T4) zu beobachten.

Die Figur 4 zeigt ein schematisches Diagramm welches den, mittels dem seriellen Widerstand 162 in Reihe zu dem NTC-Widerstand 160 und dem parallelen Widerstand 164 parallel zu der Reihenschaltung aus seriellem Widerstand 162 und NTC-Widerstand 160 im Rückkoppelpfad, kompensierten Verlauf der Gesamtübertragungsfunktion in mV (pro A) über der Frequenz bei verschiedenen Temperaturen (T1, T2, T3, T4) zeigt. Im Vergleich zu der Figur 3 ist die Auffächerung der Gesamtübertragungsfunktion für geringe Frequenzen bei verschiedenen Temperaturen signifikant reduziert.

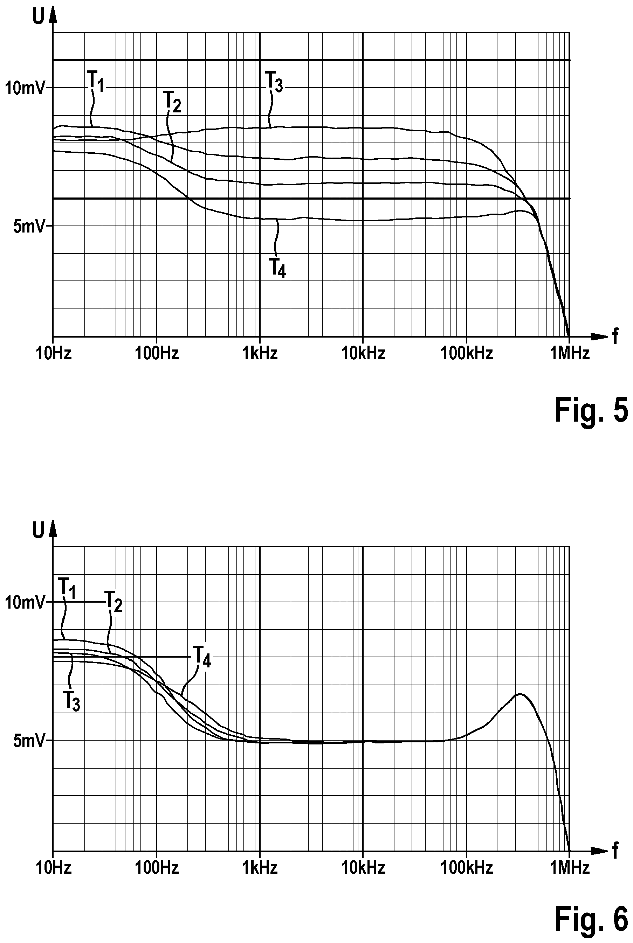

Die Figur 5 zeigt ein schematisches Diagramm welches den unkompensierten Verlauf der Gesamtübertragungsfunktion in mV (pro A) über der Frequenz bei verschiedenen Temperaturen (T1, T2, T3, T4) ohne Filterkondensatoren zeigt. Über einen großen Frequenzbereich ist ein weites Auffächern beziehungsweise Spreizen der Gesamtübertragungsfunktion bei verschiedenen Temperaturen (T1, T2, T3, T4) zu beobachten.

Die Figur 6 zeigt ein schematisches Diagramm, welches den mittels dem ersten Filterkondensator teilkompensierten Verlauf der Gesamtübertragungsfunktion in mV (pro A) über der Frequenz bei verschiedenen Temperaturen (T1, T2, T3, T4) zeigt. Im Vergleich zu der Figur 5 ist die Auffächerung der Gesamtübertragungsfunktion über einen großen Frequenzbereich bei verschiedenen Temperaturen (T1, T2, T3, T4) signifikant reduziert. Mittels des ersten Filterkondensators wird die Wirkung des NTC-Widerstands ab einer bestimmten Frequenz ausgeschaltet.

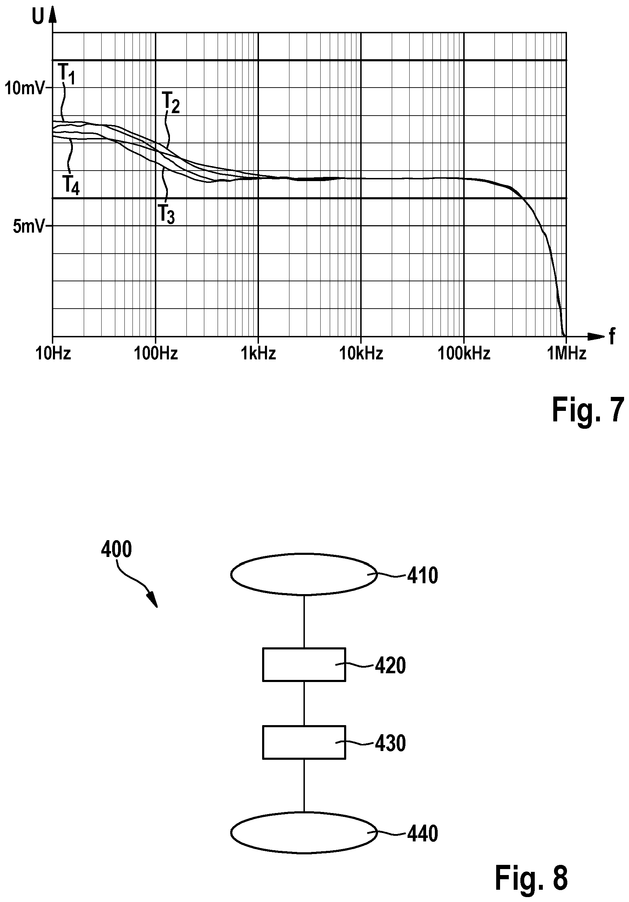

Die Figur 7 zeigt ein schematisches Diagramm welches den mittels dem ersten und dem zweiten Filterkondensator kompensierten Verlauf der Gesamtübertragungsfunktion in mV (pro A) über der Frequenz bei verschiedenen Temperaturen (T1, T2, T3, T4) zeigt. Im Vergleich zu der Figur 6 ist eine Anhebung eines Plateaus der Gesamtübertragungsfunktion über einen großen Frequenzbereich bei verschiedenen Temperaturen (T1, T2, T3, T4) zu beobachten. Mittels Dimensionierung des zweiten Filterkondensators kann die Verstärkung zu höheren Frequenzen vorgegeben werden.

Die Figur 8 zeigt ein schematisch dargestelltes Verfahren 400 zum Betrieb der Vorrichtung 200. Mit Schritt 410 startet das Verfahren 400. In Schritt 420 wird der Stroms durch eine Drossel 130 eines Spannungswandlers 100 ermittelt. In Schritt 430 wird der Spannungswandlers 100 in Abhängigkeit des ermittelten Stroms angesteuert. Mit Schritt 440 endet das Verfahren.

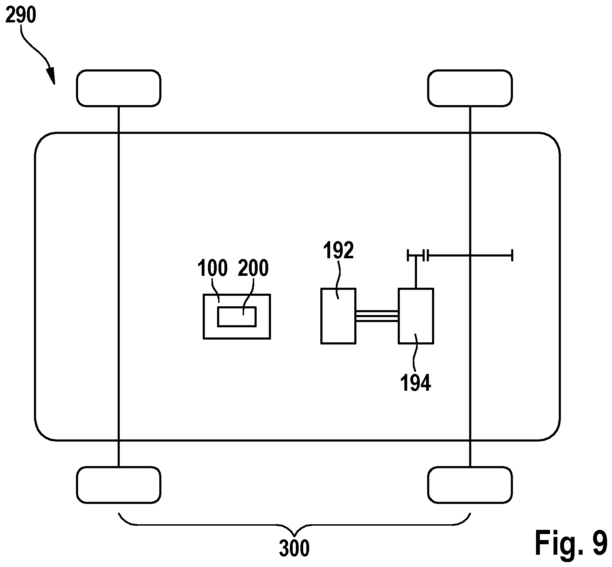

Die Figur 9 zeigt ein schematisch dargestelltes Fahrzeug 290 mit einem Antriebsstrang 300 und einem Spannungswandler 100. Der Spannungswandler umfasst die Vorrichtung 200, wie zu Figur 2 beschrieben.

Bevorzugt umfasst der elektrische Antriebsstrang eine Batterie (nicht dargestellt) zur Versorgung des Antriebsstrangs, welcher weiter bevorzugt einen Inverter 192 und/ oder eine elektrische Maschine 194 umfasst.

**Patentansprüche**

1. Vorrichtung (200) zur Messung eines Stroms durch eine Drossel (130) eines Spannungswandlers (100),

   mit einer Integratorschaltung (140), einer Verstärkerschaltung und einem NTC-Widerstand (160),
   wobei ein Laststrom des Spannungswandlers (100) durch die Drossel (130) fließt und die Drossel (130) ausgangsseitig mit einem Ausgangsanschluss (105) des Spannungswandlers (100) verbunden ist,
   wobei die Integratorschaltung (140) parallel zu der Drossel (130) angeordnet ist und eine Reihenschaltung aus einem Integratorwiderstand (142) und einem Integratorkondensator (144) umfasst,
   wobei der Integratorkondensator (144) ebenfalls mit dem Ausgangssanschluss (105) des Spannungswandlers (100) verbunden ist und ein Mittenabgriff zwischen dem Integratorwiderstand (142) und dem Integratorkondensator (144) als Ausgang der Integratorschaltung (140) ausgebildet ist und an diesem Ausgang der Integratorschaltung (140) ein Integratorausgangssignal anliegt,
   wobei die Verstärkerschaltung einen invertierenden und einen nichtinvertierenden Verstärkereingangsanschluss (152, 154) und einen Verstärkerausgangsanschluss (156) umfasst und ein den Strom durch die Drossel (130) charakterisierendes Spannungssignal am Verstärkerausgangsanschluss (156) der Verstärkerschaltung anliegt,
   wobei der NTC-Widerstand (160) im Rückkoppelpfad der Verstärkerschaltung zwischen dem invertierenden Verstärkereingangsanschluss (152) und
   dem Verstärkerausgangsanschluss (156) angeordnet ist, **dadurch gekennzeichnet, dass**
   dem nichtinvertierenden Verstärkereingangsanschluss ein Verstärkereingangssignal in Abhängigkeit des Integratorausgangssignals zugeführt wird, und
   die Vorrichtung eine Referenzspannungsquelle (170) mit einem positiven Quellenanschluss (172) und einem negativen Quellenanschluss (174) umfasst,
   wobei mittels der Referenzspannungsquelle (170) eine erste Offsetspannung am Ausgang der Integratorschaltung (140) eingekoppelt wird,
wobei
der negative Quellenanschluss (174) mit dem Ausgangsanschluss (105) des Spannungswandlers (100) verbunden ist,
und der positive Quellenanschluss (172) über einen Koppelwiderstand (176) mit dem Ausgang der Integratorschaltung (140) verbunden ist.

2. Vorrichtung (200) nach Anspruch 1,
wobei die Verstärkerschaltung einen Operationsverstärker (150) umfasst, welcher bevorzugt als nichtinvertierender Operationsverstärker arbeitet.

3. Vorrichtung (200) nach Anspruch 2 ,

   wobei mittels der Referenzspannungsquelle (170) eine zweite Offsetspannung in den Rückkoppelpfad an dem invertierenden Verstärkereingangsanschluss (152) der Verstärkerschaltung eingekoppelt wird,
   wobei bevorzugt der negative Quellenanschluss (174) mit dem Ausgangsanschluss (105) des Spannungswandlers (100) verbunden ist,
   und der positive Quellenanschluss (172) über einen Spannungsteiler aus einem ersten, zweiten und dritten Spannungsteilerwiderstand (177, 178, 179) mit dem Ausgangsanschluss (105) des Spannungswandlers (100) verbunden ist und ein Abgriff zwischen dem zweiten und dem dritten Spannungsteilerwiderstand (178, 179) mit dem invertierenden Verstärkereingangsanschluss (152) verbunden ist.

4. Vorrichtung (200) nach einem der vorhergehenden Ansprüche,
wobei in dem Rückkoppelpfad der Verstärkerschaltung zwischen dem invertierenden Verstärkereingangsanschluss (152) und dem Verstärkerausgangsanschluss (156) ein serieller Widerstand (162) in Reihe zu dem NTC-Widerstand (160) und ein paralleler Widerstand (164) parallel zu der Reihenschaltung aus seriellem Widerstand (162) und NTC-Widerstand (160) angeordnet ist.

5. Vorrichtung (200) nach einem der vorhergehenden Ansprüche,
wobei ein erster Filterkondensator (166) parallel zu dem NTC-Widerstand (160) angeordnet ist.

6. Vorrichtung (200) nach Anspruch 3, oder nach Anspruch 4 wenn abhängig von Anspruch 3, oder nach Anspruch 5 wenn abhängig von Anspruch 3,
wobei ein zweiter Filterkondensator (168) parallel zu dem ersten Spannungsteilerwiderstand (177) oder dem zweiten Spannungsteilerwiderstand (178) angeordnet ist.

7. Spannungswandler (100) mit einer Vorrichtung (200) nach einem der Ansprüche 1 bis 6,
wobei der Spannungswandler als Wechselrichter, als Gleichspannungswandler oder als Ladegerät ausgebildet ist.

8. Antriebsstrang (300) eines Fahrzeugs (290) mit einem Spannungswandler (100) gemäß Anspruch 7.

9. Fahrzeug (290) mit einem Antriebsstrang (300) nach Anspruch 8.

10. Verfahren (400) zum Betrieb einer Vorrichtung (200) nach einem der Ansprüche 1-9,
mit den Schritten:

    Ermitteln (420) des Stroms durch eine Drossel (130) eines Spannungswandlers (100)
    Steuern (430) des Spannungswandlers (100) in Abhängigkeit des ermittelten Stroms.

11. Computerprogramm, umfassend Befehle, die bei der Ausführung des Programms durch einen Computer diesen veranlassen, das Verfahren/die Schritte des Verfahrens (400) nach Anspruch 10 auszuführen.

12. Computerlesbares Speichermedium, umfassend Befehle, die bei der Ausführung durch einen Computer diesen veranlassen, das Verfahren/die Schritte des Verfahrens (400) nach Anspruch 10 auszuführen.

**Claims**

1. Device (200) for measuring a current through a choke (130) of a voltage converter (100),

   having an integrator circuit (140), an amplifier circuit and an NTC resistor (160),
   wherein a load current of the voltage converter (100) flows through the choke (130) and the output side of the choke (130) is connected to an output terminal (105) of the voltage converter (100),
   wherein the integrator circuit (140) is arranged in parallel with the choke (130) and comprises a series circuit comprising an integrator resistor (142) and an integrator capacitor (144),
   wherein the integrator capacitor (144) is also connected to the output terminal (105) of the voltage converter (100) and a centre tap between the integrator resistor (142) and the integrator capacitor (144) is designed as the output of the integrator circuit (140) and an integrator output signal is present at this output of the integrator circuit (140),

wherein the amplifier circuit comprises an inverting and a non-inverting amplifier input terminal (152, 154) and an amplifier output terminal (156) and a voltage signal characterizing the current through the choke (130) is present at the amplifier output terminal (156) of the amplifier circuit, wherein

the NTC resistor (160) is arranged in the feedback path of the amplifier circuit between the inverting amplifier input terminal (152) and the amplifier output terminal (156), **characterized in that** the non-inverting amplifier input terminal is supplied with an amplifier input signal as a function of the integrator output signal, and the device comprises a reference voltage source (170) having a positive source terminal (172) and a negative source terminal (174),

wherein the reference voltage source (170) is used to couple in a first offset voltage at the output of the integrator circuit (140),

wherein the negative source terminal (174) is connected to the output terminal (105) of the voltage converter (100),

and the positive source terminal (172) is connected to the output of the integrator circuit (140) via a coupling resistor (176).

2. Device (200) according to Claim 1, wherein the amplifier circuit comprises an operational amplifier (150) which preferably operates as a non-inverting operational amplifier.

3. Device (200) according to Claim 2,

wherein the reference voltage source (170) is used to couple a second offset voltage into the feedback path at the inverting amplifier input terminal (152) of the amplifier circuit,

wherein preferably the negative source terminal (174) is connected to the output terminal (105) of the voltage converter (100), and the positive source terminal (172) is connected to the output terminal (105) of the voltage converter (100) via a voltage divider consisting of a first, second and third voltage divider resistor (177, 178, 179) and a tap between the second and third voltage divider resistors (178, 179) is connected to the inverting amplifier input terminal (152).

4. Device (200) according to one of the preceding claims,
wherein in the feedback path of the amplifier circuit between the inverting amplifier input terminal (152) and the amplifier output terminal (156), a series resistor (162) is arranged in series with the NTC resistor (160) and a parallel resistor (164) is arranged in parallel with the series circuit comprising series resistor (162) and NTC resistor (160).

5. Device (200) according to one of the preceding claims,
wherein a first filter capacitor (166) is arranged in parallel with the NTC resistor (160).

6. Device (200) according to Claim 3, or according to Claim 4 if dependent on Claim 3, or according to Claim 5 if dependent on Claim 3,
wherein a second filter capacitor (168) is arranged in parallel with the first voltage divider resistor (177) or the second voltage divider resistor (178).

7. Voltage converter (100) having a device (200) according to one of Claims 1 to 6,
wherein the voltage converter is in the form of an inverter, a DC-DC voltage converter or a charger.

8. Drive train (300) of a vehicle (290) having a voltage converter (100) according to Claim 7.

9. Vehicle (290) having a drive train (300) according to Claim 8.

10. Method (400) for operating a device (200) according to one of Claims 1-9, having the steps of:
ascertaining (420) the current through a choke (130) of a voltage converter (100) controlling (430) the voltage converter (100) on the basis of the ascertained current.

11. Computer program comprising commands which, when the program is executed by a computer, cause the latter to perform the method/the steps of the method (400) according to Claim 10.

12. Computer-readable storage medium comprising commands which, when executed by a computer, cause the latter to perform the method/the steps of the method (400) according to Claim 10.

**Revendications**

1. Dispositif (200) permettant de mesurer un courant à travers une bobine d'arrêt (130) d'un convertisseur de tension (100),

comprenant un circuit intégrateur (140), un circuit amplificateur et une résistance CTN (160), dans lequel un courant de charge du convertisseur de tension (100) circule à travers la bobine d'arrêt (130), et la bobine d'arrêt (130) est reliée côté sortie à une borne de sortie (105) du convertisseur de tension (100),

dans lequel le circuit intégrateur (140) est disposé en parallèle à la bobine d'arrêt (130) et comprend un montage en série composé d'une résistance d'intégrateur (142) et d'un condensateur d'intégrateur (144),
dans lequel le condensateur d'intégrateur (144) est également relié à la borne de sortie (105) du convertisseur de tension (100), et une prise centrale est réalisée entre la résistance d'intégrateur (142) et le condensateur d'intégrateur (144) en tant que sortie du circuit intégrateur (140) et un signal de sortie d'intégrateur est appliqué à cette sortie du circuit intégrateur (140), dans lequel le circuit amplificateur comprend une borne d'entrée d'amplificateur (152, 154) inverseuse et non inverseuse et une borne de sortie d'amplificateur (156), et
un signal de tension caractérisant le courant à travers la bobine d'arrêt (130) est appliqué à la borne de sortie d'amplificateur (156),
dans lequel
la résistance CTN (160) est disposée dans le chemin de rétroaction du circuit amplificateur entre la borne d'entrée d'amplificateur inverseuse (152) et
la borne de sortie d'amplificateur (156), **caractérisé en ce qu'**un signal d'entrée d'amplificateur est amené à la borne d'entrée d'amplificateur non inverseuse en fonction du signal de sortie d'intégrateur, et le dispositif comprend une source de tension de référence (170) pourvue d'une borne de source positive (172) et d'une borne de source négative (174),
dans lequel une première tension de décalage est injectée à la sortie du circuit intégrateur (140) au moyen de la source de tension de référence (170), dans lequel la borne de source négative (174) est reliée à la borne de sortie (105) du convertisseur de tension (100),
et la borne de source positive (172) est reliée à la sortie du circuit intégrateur (140) par l'intermédiaire d'une résistance de couplage (176).

**2.** Dispositif (200) selon la revendication 1,
dans lequel le circuit amplificateur comprend un amplificateur opérationnel (150) qui fonctionne de préférence en tant qu'amplificateur opérationnel non inverseur.

**3.** Dispositif (200) selon la revendication 2,
dans lequel une deuxième tension de décalage est injectée dans le chemin de rétroaction au moyen de la source de tension de référence (170) à la borne d'entrée d'amplificateur inverseuse (152) du circuit amplificateur, dans lequel de préférence la borne de source négative (174) est reliée à la borne de sortie (105) du convertisseur de tension (100), et la borne de source positive (172) est reliée par l'intermédiaire d'un diviseur de tension composé d'une première, d'une deuxième et d'une troisième résistance de diviseur de tension (177, 178, 179) à la borne de sortie (105) du convertisseur de tension (100), et une prise est reliée entre la deuxième et la troisième résistance de diviseur de tension (178, 179) à la borne d'entrée d'amplificateur inverseuse (152).

**4.** Dispositif (200) selon l'une quelconque des revendications précédentes, dans lequel, dans le chemin de rétroaction du circuit amplificateur, entre la borne d'entrée d'amplificateur inverseuse (152) et la borne de sortie d'amplificateur (156), une résistance série (162) est disposée en série avec la résistance CTN (160), et une résistance parallèle (164) est disposée en parallèle au montage en série composé d'une résistance série (162) et d'une résistance NTC (160).

**5.** Dispositif (200) selon l'une quelconque des revendications précédentes, dans lequel un premier condensateur de filtrage (166) est disposé en parallèle à la résistance CTN (160).

**6.** Dispositif (200) selon la revendication 3 ou la revendication 4 lorsque dépendant de la revendication 3, ou selon la revendication 5 lorsque dépendant de la revendication 3,
dans lequel un deuxième condensateur de filtrage (168) est disposé en parallèle à la première résistance de diviseur de tension (177) ou à la deuxième résistance de diviseur de tension (178).

**7.** Convertisseur de tension (100), comprenant un dispositif (200) selon l'une quelconque des revendications 1 à 6,
dans lequel le convertisseur de tension est réalisé sous forme d'onduleur, de convertisseur CC/CC ou de chargeur.

**8.** Chaîne cinématique (300) d'un véhicule (290), comprenant un convertisseur de tension (100) selon la revendication 7.

**9.** Véhicule (290), comprenant une chaîne cinématique (300) selon la revendication 8.

**10.** Procédé (400) permettant de faire fonctionner un dispositif (200) selon l'une quelconque des revendications 1 à 9,
comprenant les étapes consistant à :

établir (420) le courant à travers une bobine d'arrêt (130) d'un convertisseur de tension (100), commander (430) le convertisseur de tension (100) en fonction du courant établi.

**11.** Programme informatique, comprenant des instructions qui, lors de l'exécution du programme par un ordinateur, amènent celui-ci à exécuter le procédé/les étapes du procédé (400) selon la revendication 10.

**12.** Support de stockage lisible par ordinateur comprenant des instructions qui, lorsqu'elles sont exécutées par un ordinateur, amènent celui-ci à exécuter le procédé/les étapes du procédé (400) selon la revendication 10.

Fig. 1

EP 4 073 525 B1

Fig. 2

**Fig. 3**

**Fig. 4**

Fig. 5

Fig. 6

Fig. 7

Fig. 8

290

100 200

192

194

300

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 104638885 B
- US 2018340964 A1
- KR 20110012116 A
- JP 2010011294 A

**In der Beschreibung aufgeführte Nicht-Patentliteratur**

- Temperature compensated high efficiency inductor current sensor. **TSANG KM et al.** SENSORS AND ACTUATORS A: PHYSICAL. ELSEVIER BV, 31. August 2009, vol. 154, 16-22

- Temperatur-Kompensation elektrischer Groessen. **LEVIGION M.** TECHNISCHES MESSEN ATM. R.OLDENBOURG VERLAG, 01. September 1973, vol. 2119-8, 177-180